Europäisches Patentamt

European Patent Office

Office européen des brevets

(19)

(11) Publication number: 0 357 503
A2

# EUROPEAN PATENT APPLICATION

(12)

(21) Application number: 89402356.3

(22) Date of filing: 29.08.89

(51) Int. Cl.5: G 11 C 17/00

(30) Priority: 30.08.88 JP 216064/88

(43) Date of publication of application:
07.03.90 Bulletin 90/10

(84) Designated Contracting States: DE FR GB

(71) Applicant: FUJITSU LIMITED
1015, Kamikodanaka Nakahara-ku
Kawasaki-shi Kanagawa 211 (JP)

(72) Inventor: Matsuzaki, Yasurou
3-4-13, Sekido
Tama-shi Tokyo 206 (JP)

Tsuchimoto, Yuji
320, Imainakamachi Nakahara-ku
Kawasaki-shi Kanagawa 211 (JP)

Mutoh, Yoshikazu
1476-3, Shimokodanaka Nakahara-ku
Kawasaki-shi Kanagawa 211 (JP)

Takahashi, Masaki
19-4, Ohgane
Mizusawa-shi Iwate 023 (JP)

(74) Representative: Joly, Jean-Jacques et al
CABINET BEAU DE LOMENIE 55, rue d'Amsterdam
F-75008 Paris (FR)

(54) Programmable read only memory having bipolar complementary metal oxide semiconductor structure.

(57) A PROM having a BiCMOS structure comprises a memory cell array (2) having a plurality of memory cells each connected to one of a plurality of bit lines and one of a plurality of word lines, an address transition detector (14) supplied with an address signal for detecting an address transition and for outputting a detection signal, a single variable load circuit (15) coupled to the address transition detector and having a load which is variably controlled responsive to the detection signal received from the address transition detector, a word line selection circuit (12) for selecting an arbitrary word line responsive to the address signal, and a bit line selection circuit (11) for selecting an arbitrary bit line responsive to the address signal and for supplying a current to only the selected arbitrary bit line, the current having a value dependent on the load of the variable load circuit.

FIG.4

EP 0 357 503 A2

**Description**

# PROGRAMMABLE READ ONLY MEMORY HAVING BIPOLAR COMPLEMENTARY METAL OXIDE SEMICONDUCTOR STRUCTURE

## BACKGROUND OF THE INVENTION

The present invention generally relates to programmable read only memories (PROMs), and more particularly to a PROM having a bipolar complementary metal oxide semiconductor (BiCMOS) structure.

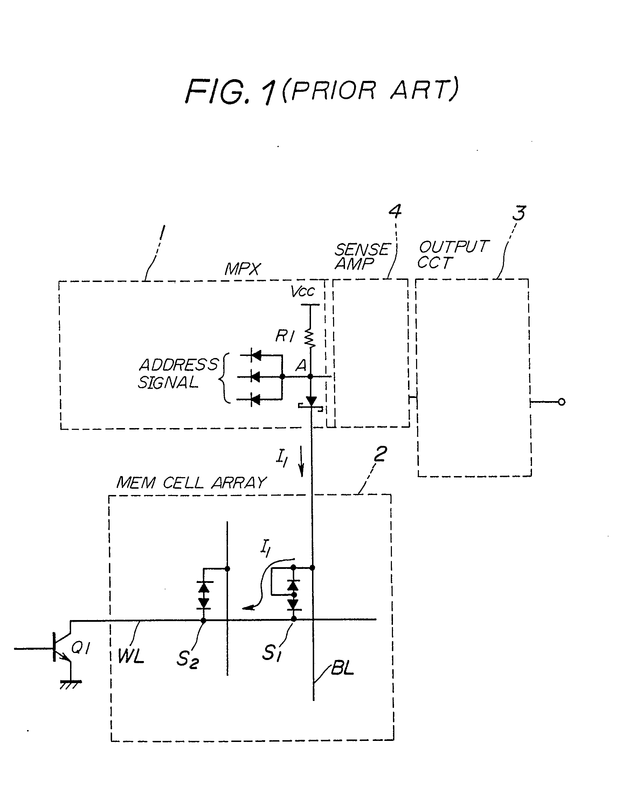

FIG.1 shows an essential part of an example of a conventional PROM having the BiCMOS structure. A multiplexer 1 selects a predetermined bit line BL responsive to an address signal. Such a multiplexer 1 is provided with respect to each bit line BL. On the other hand, a word line selection transistor Q1 is turned ON responsive to the address signal and selects a predetermined word line WL. In this example, a written cell S1 is selected, and a bit line current I1 flows through the written cell S1 of a memory cell array 2. But when a non-written cell S2 is selected, the bit line current I1 does not flow. An output circuit 3 is turned ON when the non-written cell S2 is selected and turned OFF when the written cell S1 is selected depending on a potential at a node A. This potential at the node A is dependent on the existence of the bit line current I1. The signal obtained from the node A is output via the output circuit 3 as a read out signal.

The bit line current I1 which is supplied to the selected bit line BL is determined by a resistance of a resistor R1 through which a current is supplied to the selected bit line BL and the sense amplifier 4. In other words, (i) the resistance of the resistor R1 must be set to a relatively small value such that the bit line current I1 is large in order to realize a high speed operation of the PROM. On the other hand, (ii) the resistance of the resistor R1 must be set to a relatively large value such that the bit line current I1 is small in order to realize a low power consumption. In addition, (iii) the resistance of the resistor R1 must be set to a relatively large value such that the bit line current I1 is small in order to realize a high reliability. But in the case of the PROM, the grow back phenomenon occurs when a relatively large bit line current I1 flows through the written cell S1 for a long time and the grow back phenomenon returns the written cell S1 into a non-written cell.

The above requirement (i) contradicts with the requirements (ii) and (iii). That is, the resistance of the resistor R1 needs to be small to realize the high-speed operation, but the resistance of the resistor R1 needs to be large to realize the low power consumption and the high reliability. The high reliability of the PROM has priority over other features, and the resistance of the resistor R1 conventionally cannot be set to an extremely small value.

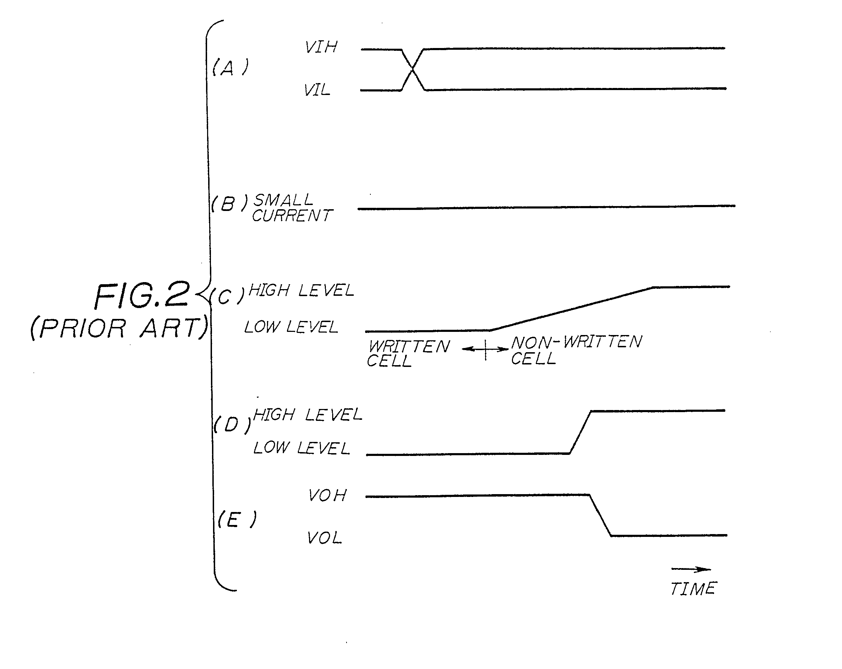

FIGS.2(A) through 2(E) show timing charts for explaining the operation of the conventional PROM. FIG.2(A) shows the address signal voltage, FIG.2(B) shows the bit line current I1, FIG.2(C) shows a bit line voltage, FIG.2(D) shows an output voltage of the sense amplifier 4, and FIG.2(E) shows an output terminal voltage output from the output circuit 3. As may be seen from FIG.2(C), it is impossible to sharply raise the bit line voltage. As a result, the responses of the sense amplifier 4 and the output circuit 3 are poor as shown in FIGS.2(D) and 2(E) and there is a problem in that a sufficiently high-speed operation cannot be realized. In the case where the written cell S1 is selected, the bit line current I1 flows through the written cell S1 and the output circuit 3 is quickly turned OFF.

On the other hand, a Japanese Laid-Open Patent Application No.61-190787 proposes a static random access memory (SRAM) having an address transition detector which detects a transition of the address signal and a variable load circuit which has an impedance which decreases responsive to an output detection signal of the address transition detector when the address transition occurs. This arrangement is intended to reduce the power consumption when a memory cell is not selected and to increase the read speed and write speed when a memory cell is selected.

But the above proposed arrangement for reducing the power consumption and increasing the operation speed is applied to the SRAM and not the PROM. The SRAM and PROM operate quite differently and the proposed arrangement is not applicable to the PROM. That is, the SRAM supplies the bit line current to all of the bit lines, but the PROM supplies the bit line current to only the selected bit line. Hence, when the proposed arrangement is applied to the PROM, the bit line current is supplied to all of the bit lines including the selected bit line. However, it is undesirable to supply the bit line current to all of the bit lines of the PROM because the power consumption increases unnecessarily and the written cells may return to the non-written cells due to the grow back phenomenon caused by the bit line current which is frequently supplied to all of the bit lines. In the latter case, the reliability of the PROM becomes poor. On the other hand, the proposed arrangement requires the variable load circuit to be provided with respect to each bit line, that is, the number of variable load circuits required is equal to the number of bit lines. But the large number of variable load circuits occupy a large chip area of the SRAM and the integration density of the SRAM is poor. For this reason, there is a problem in that the integration density of the PROM becomes poor when the proposed arrangement is applied thereto.

Therefore, the conventional PROM suffers problems in that it is impossible to simultaneously satisfy all of the requirements which are (i) high-speed operation, (ii) low power consumption, (iii) high reliability, and (iv) high integration density.

## SUMMARY OF THE INVENTION

Accordingly, it is a general object of the present invention to provide a novel and useful PROM in which the problems described above are eliminated.

Another and more specific object of the present invention is to provide a PROM having a BiCMOS structure comprising a memory cell array having a plurality of memory cells each connected to one of a plurality of bit lines and one of a plurality of word lines, an address transition detector supplied with an address signal for detecting an address transition and for outputting a detection signal, a single variable load circuit coupled to the address transition detector and having a load which is variably controlled responsive to the detection signal received from the address transition detector, a word line selection circuit for selecting an arbitrary word line responsive to the address signal, and a bit line selection circuit for selecting an arbitrary bit line responsive to the address signal and for supplying a current to only the selected arbitrary bit line, the current having a value dependent on the load of the variable load circuit. According to the PROM of the present invention, it is possible to quickly raise the potential of the selected bit line by supplying a large bit line current to the selected bit line when the address transition occurs. Hence, it is possible to realize a high-speed operation of the PROM. On the other hand, in the steady state where no address transition occurs, a small bit line current is supplied to the selected bit line making it possible to realize a low power consumption and high reliability. In addition, the integration density of the PROM is virtually unaffected by the provision of the variable load circuit because only a single variable load circuit is required.

Other objects and further features of the present invention will be apparent from the following detailed description when read in conjunction with the accompanying drawings.

BRIEF DESCRIPTION OF THE DRAWINGS

FIG.1 is a circuit diagram showing an essential part of an example of a conventional PROM;

FIGS.2(A) through 2(E) are timing charts for explaining the operation of the conventional PROM;

FIG.3 is a system block diagram generally showing a PROM according to the present invention for explaining an operating principle thereof;

FIG.4 is a circuit diagram showing an essential part of a first embodiment of the PROM according to the present invention;

FIG.5 is a system block diagram showing the first embodiment of the PROM according to the present invention in its entirety;

FIGS.6(A) through 6(F) are timing charts for explaining the operation of the first embodiment;

FIGS.7A and 7B are circuit diagrams respectively showing essential parts of an address buffer circuit;

FIG.8 is a circuit diagram showing an embodiment of an address transition detector;

FIG.9 is a circuit diagram showing an output circuit; and

FIG.10 is a circuit diagram showing an essential part of a second embodiment of the PROM according to the present invention.

DESCRIPTION OF THE PREFERRED EMBODIMENTS

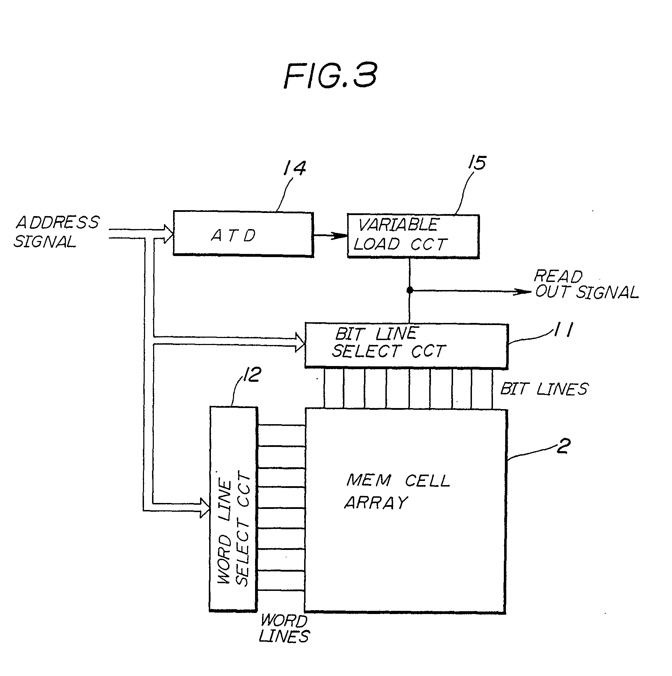

FIG.3 generally shows a PROM according to the present invention for explaining an operating principle thereof. The PROM has a BiCMOS structure and generally comprises a memory cell array 2, a bit line selection circuit 11, a word line selection circuit 12, an address transition detector 14 and a variable load circuit 15. The bit line selection circuit 11 selects a bit line responsive to the address signal, and the word line selection circuit 12 selects a word line responsive to the address signal. The address transition detector 14 detects a transition of the address signal, that is, an address transition. The variable load circuit 15 is connected to a plurality of bit lines of the memory cell array 2 and a load of the variable load circuit 15 changes depending on an output detection signal of the address transition detector 14. A junction of a memory cell within the memory cell array 2 is destroyed and short-circuited when data is written into this memory cell.

When an address transition occurs, the address transition detector 14 outputs a low-level detection signal and the load of the variable load circuit 15 is set to a small value thereby. Hence, a bit line current which is supplied to the selected bit line becomes large. Accordingly, the bit line voltage can be raised at a high speed especially when the selected cell is switched from a written cell to a non-written cell, and it is thus possible to realize an extremely short access time, that is, to realize a high-speed operation. In a steady state where no address transition takes place, the address transition detector 14 constantly outputs a high-level detection signal and the load of the variable load circuit 15 is set to a large value. Thus, the bit line current which is supplied to the selected bit line becomes small. Accordingly, it is possible to realize a low power consumption a high reliability because there is no possibility of the grow back phenomenon occurring. Furthermore, it is only necessary to provide a single variable load circuit 15 with respect to the plurality of bit lines and the provision of the variable load circuit 15 does not deteriorate the integration density of the PROM.

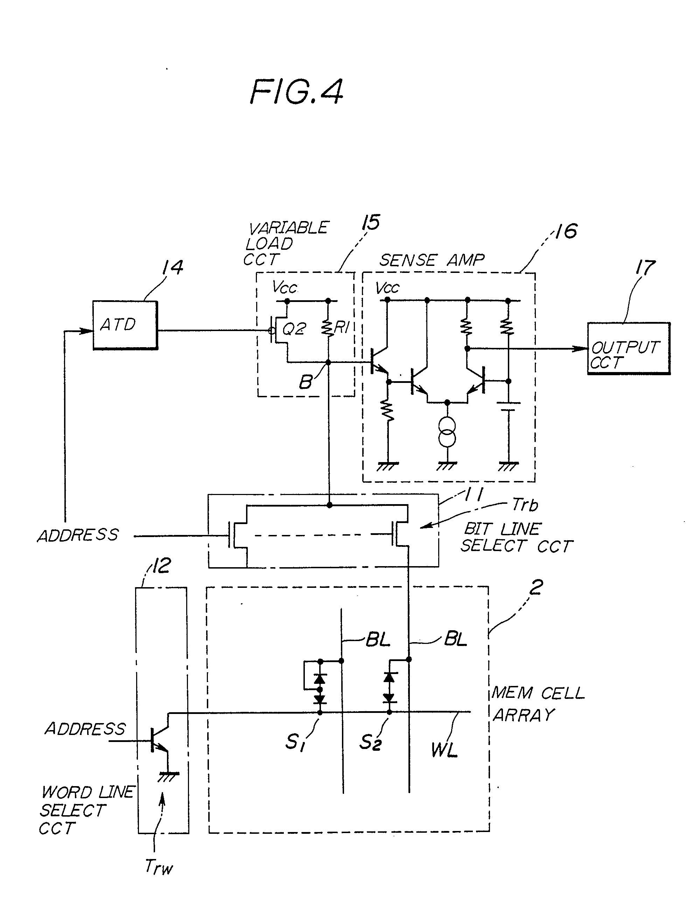

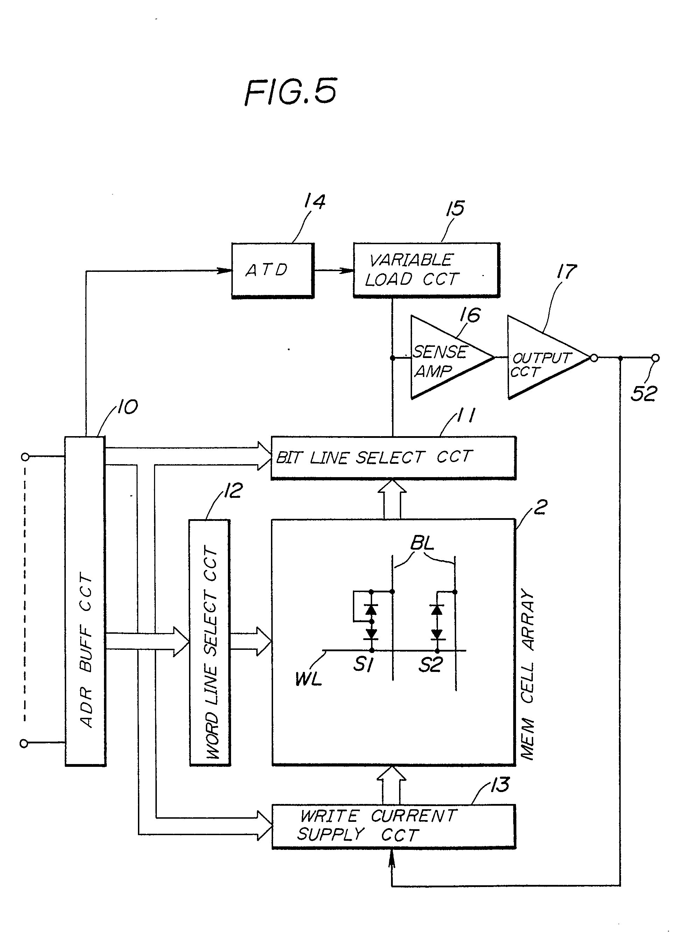

Next, a description will be given of a first embodiment of the PROM according to the present invention, by referring to FIGS.4 and 5. FIG.4 shows an essential part of the first embodiment and FIG.5 shows the first embodiment in its entirety. In FIGS.4 and 5, those parts which are the same as those corresponding parts in FIG.3 are designated by the same reference numerals, and a description thereof will be omitted.

In FIG.5, an address buffer circuit 10 generates the address signal which is used for the bit line selection in the bit line selection circuit 11 and the word line selection in the word line selection circuit 12. As shown in FIG.4, the bit line selection circuit 11 comprises a plurality of bit line selection transistors Trb, and the word line selection circuit 12 comprises a plurality of word line selection transistors Trw. The bit line selection circuit 11 and the word line selection circuit 12 respectively select a bit line BL and a word line WL responsive to the address which is received from the address buffer circuit 10. A write current supplying circuit 13 supplies a write current to a predetermined memory cell which is selected by the address from the address buffer circuit 10 when writing data into the memory cell array 2. The address transition detector 14 detects a timing of the address transition. As shown in FIG.3, the variable load circuit 15 comprises a p-channel MOS transistor Q1 and a resistor R1 which are connected in parallel between a power source Vcc and ground. The variable load circuit 15 is provided with respect to a plurality of bit lines BL. A sense amplifier 16 and an output circuit 17 are turned ON and OFF depending on a potential at a node B which is determined by whether a written cell S1 or a non-written cell S2 is selected.

In this embodiment, the variable load circuit 15 which has the load dependent on the output detection signal of the address transition detector 14 is connected with respect to the plurality of bit lines BL. The load of the variable load circuit 15 is set to a small value when the address transition occurs (that is, when the selected bit line BL is switched) so as to obtain a large bit line current I1 and realize a high-speed operation. In a steady state where the address transition does not occur, the load of the variable load circuit 15 is set to a large value so as to obtain a small bit line current I1 and realize a low power consumption and a high reliability.

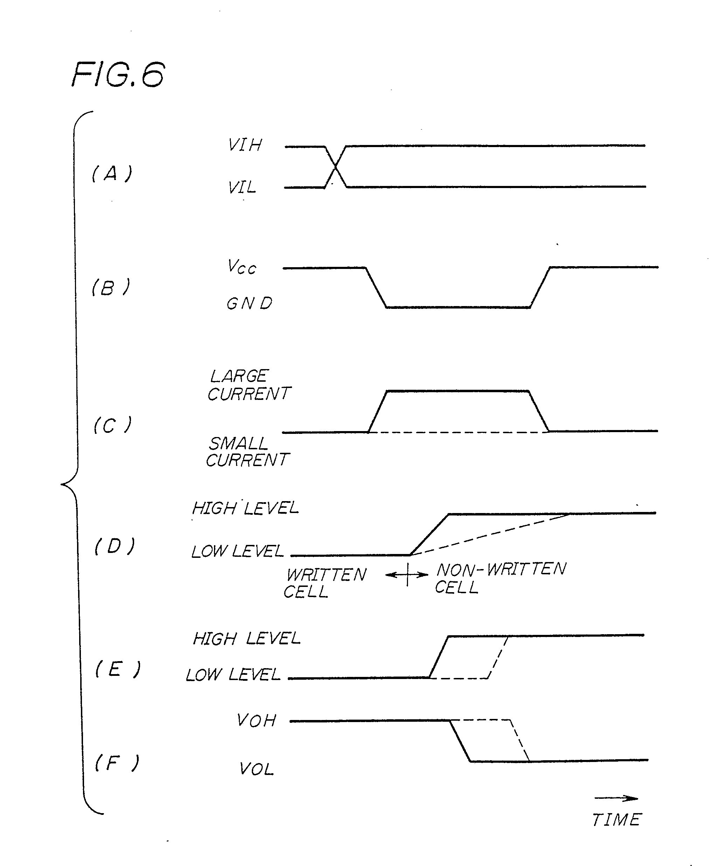

Next, a description will be given of the operation of the first embodiment by referring to FIGS.6(A) through 6(F). FIG.6(A) shows the address signal voltage, FIG.6(B) shows the output detection signal of the address transition detector 14, FIG.6(C) shows the bit line current I1, FIG.6(D) shows a bit line voltage, FIG.6(E) shows an output voltage of the sense amplifier 16, and FIG.6(F) shows an output terminal voltage output from the output circuit 17. In FIGS.6(A) and 6(C) through 6(F), the signal levels shown in FIGS.2(A) through 2(E) and obtained in the conventional PROM are indicated by phantom lines for easy comparison.

When the address signal voltage changes as shown in FIG.6(A) and the address transition detector 14 detects the address transition (switching of the selected bit line BL), the output detection signal of the address transition detector 14 changes to the ground level GND as shown in FIG.6(B). Hence, the transistor Q2 of the variable load circuit 15 turns ON and the load of the variable load circuit 15 becomes small. As a result, the bit line current I1 becomes large as shown in FIG.6(C). Especially in the case where the non-written cell S2 is selected, the bit line voltage which also flows to the sense amplifier 16 changes to a high level with a relatively sharp rise as shown in FIG.6(D). Therefore, the output voltage of the sense amplifier 16 rises with a satisfactory response as shown in FIG.6(E) and the output terminal voltage of the output circuit 17 falls to the low level with a satisfactory response as shown in FIG.6(F). This means that when the selected cell is switched from the written cell S1 to the non-written cell S2, the bit line voltage rises sharply and the access time of the PROM is short.

On the other hand, in the steady state where the no address transition occurs and the non-written cell S2 is selected, the output detection signal of the address transition detector 14 is fixed to the high level as shown in FIG.6(B) and the transistor Q2 of the variable load circuit 15 is OFF. Hence, the load of the variable load circuit 15 is large and the bit line current I1 is small as shown in FIG.6(C). Consequently, it is possible to realize a low power consumption.

When the written cell S1 is selected, the bit line current I1 flows through the written cell S1 similarly as in the case of the conventional PROM. As a result, the output voltage of the sense amplifier 16 falls to the low level and the output terminal voltage of the output circuit 17 rises to the high level. Even in the steady state where the written cell S1 is selected, the low power consumption can be realized because the transistor Q2 of the variable load circuit 15 is OFF and the bit line current I1 is small. Moreover, it is possible to realize a high reliability because there is no possibility of the grow back phenomenon occurring.

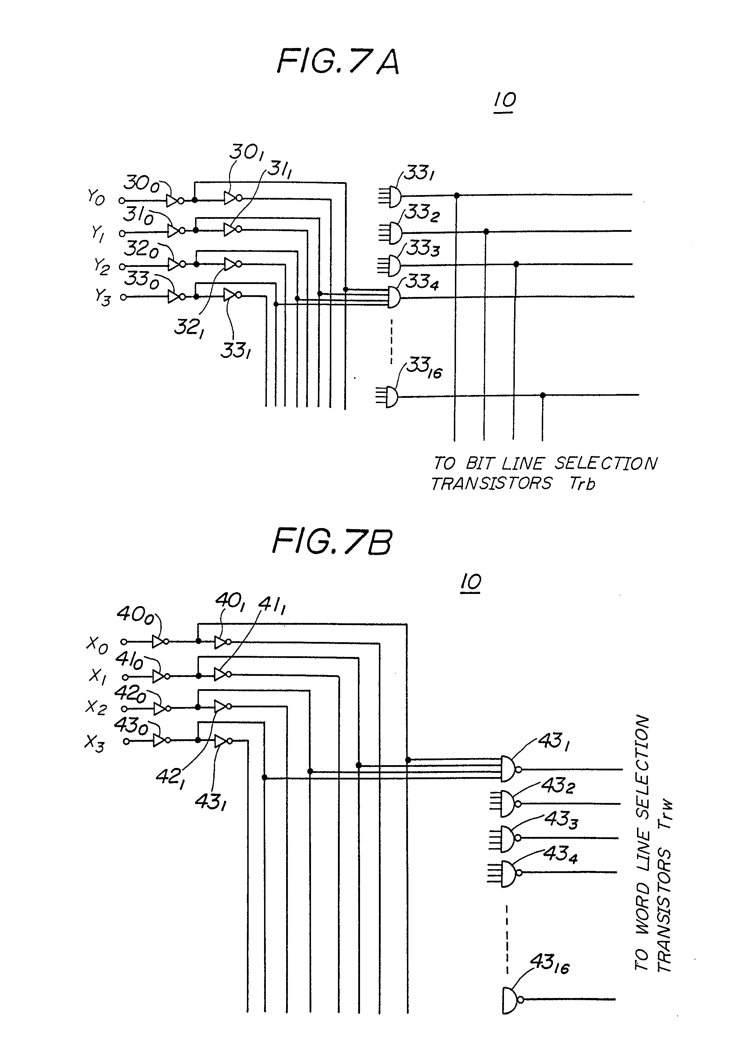

FIGS.7A and 7B respectively show essential parts of the address buffer circuit 10. FIG.7A shows a part of the address buffer circuit 10 related to a Y-address and FIG.7B shows a part of the address buffer circuit 10 related to an X-address. In FIGS.7A and 7B, it is assumed for the sake of convenience that the Y-address and the X-address each have four bits.

In FIG.7A, an address bit Yi is inverted two times in respective inverters $3i_0$ and $3i_1$, where $i = 0, 1, 2, 3$. Each of sixteen AND circuits $33_1$ through $33_{16}$ receive output signals of four inverters out of the eight inverters $30_0$, $30_1$, $31_0$, ..., $33_1$. Only the connections related to the AND circuit $33_4$ are shown in FIG.7A. Output signals of the AND circuits $33_1$ through $33_{16}$ are supplied to the corresponding bit line selection transistors Trb of the bit line selection circuit 11.

In FIG.7B, an address bit Xi is inverted two times in respective inverters $4i_0$ and $4i_1$, where $i = 0, 1, 2, 3$. Each of sixteen AND circuits $43_1$ through $43_{16}$ receive output signals of four inverters out of the eight inverters $40_0$, $40_1$, $41_2$, ..., $43_1$. Only the connections related to the AND circuit $43_1$ are shown in FIG.7B. Output signals of the AND circuits $43_1$ through $43_{16}$ are supplied to the corresponding word line selection transistors Trw of the word line selection circuit 12.

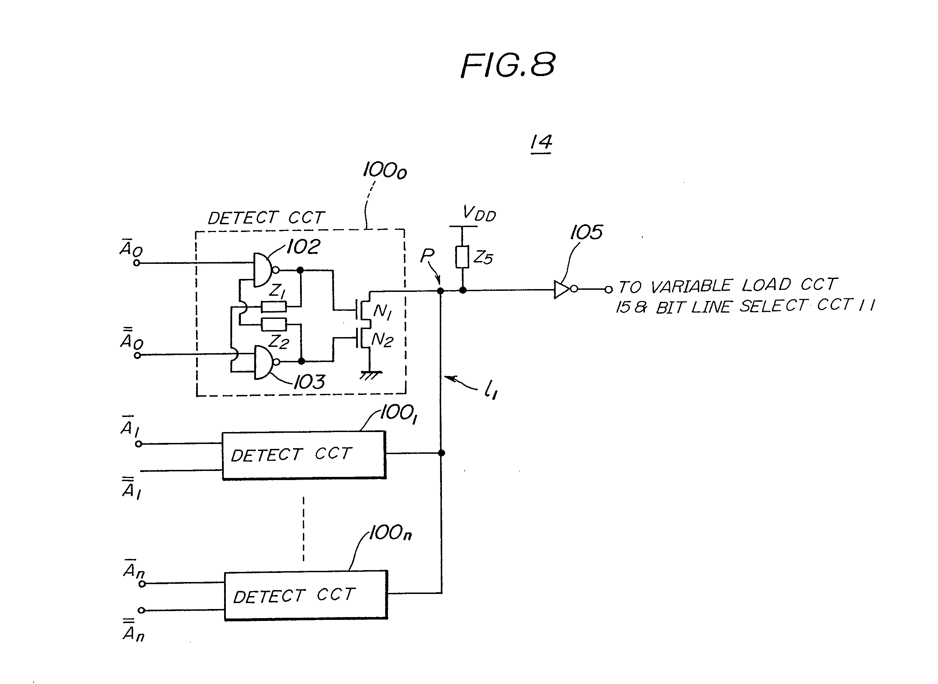

FIG.8 shows a construction of the address transition detector 14. FIG.8 shows a case where the address (Y-address or X-address) has $n + 1$ bits A0 through An. For example, when $n = 3$ and the Y-address is received from the address buffer circuit 10, a signal $\overline{A0}$ corresponds to the bit Y0 which is inverted once by the inverter 300 in FIG.7A and a signal $\overline{\overline{A0}}$ corresponds to the bit Y0 which is inverted twice by the inverters $30_0$ and $30_1$ in FIG.7A.

The address transition detector 14 generally comprises detecting circuits $100_0$ through $100_n$, a

pull-up load Z5 and an inverter 105. Because the constructions of the detecting circuits $100_0$ through $100_n$ are the same, only the construction of the detecting circuit $100_0$ is shown in FIG.8. The detecting circuit $100_0$ comprises NAND circuits 102 and 103, n-channel MOS field effect transistors (FETS) NI and N2, and loads Z1 and Z2 which are connected as shown. In FIG.8, $V_{DD}$ denotes a power source voltage.

When the address bit $\overline{A0}$ has a high level and the address bit $\overline{\overline{A0}}$ has a low level, an output signal of the NAND circuit 103 has a high level. In this state, two input signals of the NAND circuit 102 have high levels and the NAND circuit 102 outputs a low-level signal. Hence, the output signal of the NAND circuit 102 is supplied to a gate of the transistor N1 and turns the transistor N1 OFF. On the other hand, the output signal of the NAND circuit 103 is supplied to a gate of the transistor N2 and turns the transistor N2 ON.

Next, when the address bit $\overline{A0}$ changes to a low level and the address bit $\overline{\overline{A0}}$ changes to a high level, one of the input signals (that is, the address bit $\overline{A0}$) of the NAND circuit 102 has the low level. Thus, the output signal of the NAND circuit 102 changes immediately to a high level regardless of the level of the other input signal of the NAND circuit 102, that is, regardless of the level of the output signal of the NAND circuit 103.

On the other hand, one of the input signals (that is, the address bit $\overline{\overline{A0}}$) of the NAND circuit 103 has a high level, and an output signal level of the NAND circuit 103 is determined depending on the output signal level of the NAND circuit 102. As described above, the output signal of the NAND circuit 102 changes immediately from the low level to the high level, but the output signal of the NAND circuit 102 is supplied to the other input terminal of the NAND circuit 103 via the load Z1. For this reason, the signal level at the other input terminal of the NAND circuit 103 gradually rises from the low level to the high level with a time constant which is determined by the load Z1 and a stray capacitance of the other input terminal of the NAND circuit 103.

Therefore, the output signal of the NAND circuit 103 remains at the high level for a predetermined time from a time when the output signal level of the NAND circuit 102 changes to the high level until a threshold value of the NAND circuit 103 is exceeded. The output signal level of the NAND circuit 103 first changes to the low level after the predetermined time elapses.

Accordingly, the transistors N1 and N2 are ON during the predetermined time, and a current flows through a path which includes the load Z5, the transistor N1 and the transistor N2. For this reason, a potential at a node P where the load Z5, a drain of the transistor N1 and the inverter 105 connect is the low level.

After the predetermined time elapses, the transistor N1 remains ON but the transistor N2 switches from the ON state to the OFF state, and the current not longer flows through the above described path. Hence, the potential at the node P is the high level when the address bit $\overline{A0}$ has the high level and the address bit $\overline{\overline{A0}}$ has the low level. A detection signal which is obtained from the inverter 105 thus indicates an address transition. That is, the output detection signal of the inverter 105 is a positive polarity pulse which has a high level for a specific time when the address signal A0 ($\overline{A0}$, $\overline{\overline{A0}}$) changes.

The other detecting circuits $100_1$ through $100_n$ carry out operations similar to the above. As a result, when at least one bit of the address signal changes, the inverter 105 outputs the positive polarity pulse which has the high level for the specific time.

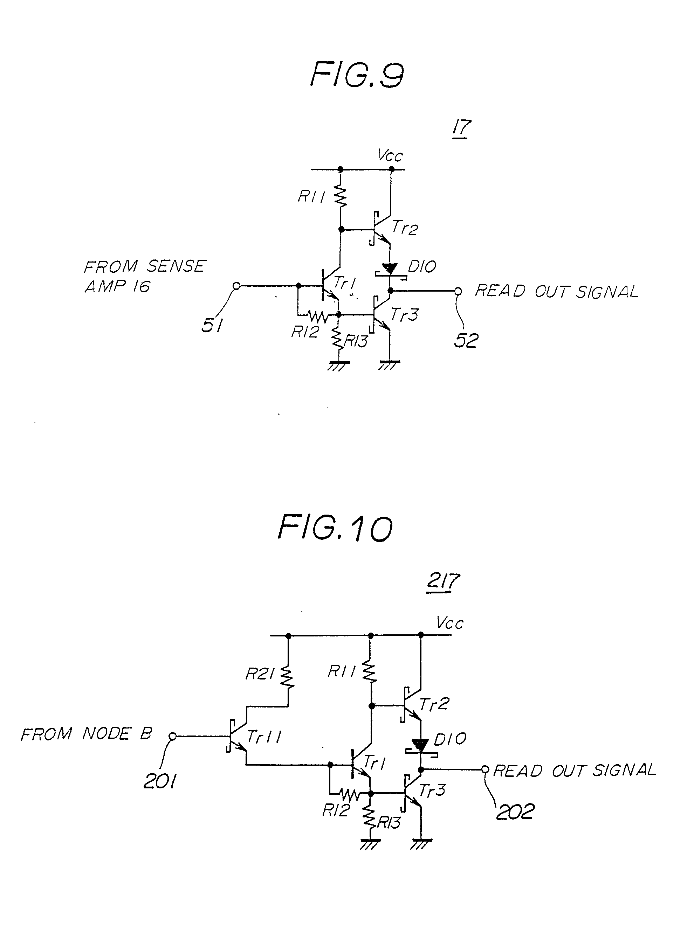

FIG.9 is shows the construction of the output circuit 17. The output circuit 17 comprises transistors Tr1 through Tr3, resistors R11 through R13, and a diode D10 which are connected as shown. The output signal of the sense amplifier 16 is applied to a terminal 51, and the read out signal is output via a terminal 52.

Next, a description will be given of a second embodiment of the PROM according to the present invention. FIG.10 shows an essential part of the second embodiment. In FIG.10, those parts which are substantially the same as those corresponding parts in FIG.9 are designated by the same reference numerals.

In this embodiment an output circuit 217 is provided in place of the sense amplifier 16 and the output circuit 17 of the first embodiment. The output circuit 217 comprises transistors Tr1, Tr2, Tr3 and Tr11, resistors R11, R12, R13 and R21, and a diode D10 which are connected as shown. The signal which is received from the node B shown in FIG.4 is applied to a terminal 201. The read out signal is output via a terminal 202.

Further, the present invention is not limited to these embodiments, but various variations and modifications may be made without departing from the scope of the present invention.

## Claims

1. A programmable read only memory having a bipolar complementary metal oxide semiconductor structure, said programmable read only memory comprising a memory cell array (2) having a plurality of memory cells, each of the memory cells being connected to one of a plurality of bit lines (BL) and one of a plurality of word lines (WL), and a word line selection circuit (12) for selecting an arbitrary word line responsive to an address signal, characterized in that there are provided: an address transition detector (14) supplied with the address signal for detecting an address transition and for outputting a detection signal; a single variable load circuit (15) coupled to said address transition detector and having a load which is variably controlled responsive to the detection signal received from said address transition detector; and a bit line selection circuit (11) for selecting an arbitrary bit line responsive to the address signal and for supplying a current to only the selected arbitrary bit line, said current having a value dependent on the load of said variable load circuit.

2. The programmable read only memory as claimed in claim 1, characterized in that there is further provided an output circuit means (16, 17, 217) which is coupled to a node (B) which connects said variable load circuit (15) and said bit line selection circuit (11) for outputting a signal read out from said memory cell array (2).

3. The programmable read only memory as claimed in claim 2, characterized in that said output circuit means (16, 17, 217) comprises a sense amplifier (16) which receives a signal from said node (B), and an output circuit (17) which receives an output signal of said sense amplifier and outputs the signal read out from said memory cell array (2).

4. The programmable read only memory as claimed in any of claims 1 to 3, characterized in that the memory cells of said memory cell array (2) respectively have a junction which is destroyed and short-circuited when written with data.

5. The programmable read only memory as claimed in any of claims 1 to 4, characterized in that said variable load circuit (15) has a first load value when the address transition occurs and the detection signal is received from said address transition detector (14) and has a second load value when no address transition occurs and no detection signal is received from said address transition detector, said first load value being smaller than said second load value.

6. The programmable read only memory as claimed in claim 5, characterized in that said variable load circuit (15) comprises a transistor (Q2) and a resistor (R1) which are connected in parallel between a power source (Vcc) and a node (B), said transistor being controlled by the detection signal received from said address transition detector (14), said node connecting said variable load circuit and said bit line selection circuit (11).

7. The programmable read only memory as claimed in any of claims 1 to 6, characterized in that there is further provided a write current supplying circuit (13) for supplying a write current to an arbitrary bit line which is selected responsive to the address signal during a write mode of the programmable read only memory.

# FIG. 1 (PRIOR ART)

FIG.2
(PRIOR ART)

(A)
VIH
VIL

(B) SMALL CURRENT

(C) HIGH LEVEL
LOW LEVEL
WRITTEN CELL ← | → NON-WRITTEN CELL

(D) HIGH LEVEL
LOW LEVEL

(E)
VOH
VOL

TIME

EP 0 357 503 A2

# FIG.3

ADDRESS
SIGNAL

14
ATD

15
VARIABLE
LOAD CCT

READ
OUT SIGNAL

11
BIT LINE
SELECT CCT

BIT LINES

12
WORD LINE SELECT CCT

2
MEM CELL
ARRAY

WORD
LINES

## FIG.4

# FIG.5

# FIG.6

(A)   VIH
      VIL

(B)   Vcc
      GND

(C)   LARGE
      CURRENT
      SMALL
      CURRENT

(D)   HIGH LEVEL
      LOW LEVEL
      WRITTEN CELL   NON-WRITTEN CELL

(E)   HIGH LEVEL
      LOW LEVEL

(F)   VOH
      VOL

TIME

## FIG.7A

*10*

TO BIT LINE SELECTION
TRANSISTORS Trb

## FIG.7B

*10*

TO WORD LINE SELECTION
TRANSISTORS Trw

# FIG.8

EP 0 357 503 A2

## FIG.9

## FIG.10